(19) **Europäisches Patentamt**

**European Patent Office**

**Office européen des brevets**

(11) **EP 0 568 424 B1**

(12) **FASCICULE DE BREVET EUROPEEN**

(45) Date de publication et mention
de la délivrance du brevet:
**04.10.2000 Bulletin 2000/40**

(51) Int. Cl.⁷: **G06F 7/00**, G06F 17/18

(21) Numéro de dépôt: **93401055.4**

(22) Date de dépôt: **22.04.1993**

(54) **Procédé d'élaboration automatique d'une représentation implicite des impliquants premiers d'une fonction**

Verfahren zur automatischen Erzeugung einer implizierten Darstellung der Primimplikanten einer Funktion

Method for automatically generating an implicit representation of the prime implicants of a function

(84) Etats contractants désignés:
**DE ES FR GB IT**

(30) Priorité: **28.04.1992 FR 9205239**

(43) Date de publication de la demande:
**03.11.1993 Bulletin 1993/44**

(73) Titulaire: **BULL S.A.**
**78430 Louveciennes (FR)**

(72) Inventeurs:
• **Coudert, Olivier**
**F-92340 Bourg la Reine (FR)**
• **Madre, Jean-Christophe**
**F-92100 Boulogne (FR)**

(74) Mandataire: **Colombe, Michel et al**
**Direction de la Propriété Intellectuelle BULL SA**
**Poste courrier:LV 58F35**
**68 route de Versailles**
**78430 Louveciennes (FR)**

(56) Documents cités:
**US-A- 4 792 909**

• **IEEE TRANSACTIONS ON COMPUTERS vol. C-35, no. 8, Août 1986, NEW YORK US pages 677 - 691 RANDAL E. BRYANT 'Graph-based Algorithms for Boolean Function Manipulation'**
• **IEEE TRANSACTIONS ON COMPUTERS vol. C-27, no. 6, Juin 1978, NEW YORK US pages 509 - 516 SHELDON B. AKERS 'Binary Decision Diagrams'**
• **PATENT ABSTRACTS OF JAPAN vol. 015, no. 391 (P-1259) 3 Octobre 1991 & JP-A-3 156 572 ( HITACHI LTD. ) 4 Juillet 1991**

**Description**

L'invention est relative à un procédé pour élaborer, de façon automatique, une représentation implicite des impliquants premiers d'une fonction booléenne, à l'aide d'un appareil de traitement de données.

La manipulation de fonctions booléennes est appliquée dans de nombreux domaines. A titre d'exemple, la synthèse, l'optimisation de circuits électroniques complexes, l'analyse de défaillances de systèmes peuvent être fondées sur une telle manipulation.

Par exemple, dans l'analyse de défaillances de systèmes, on peut représenter, à l'aide d'une fonction booléenne la survenance d'une défaillance en fonction des événements extérieurs susceptibles de provoquer cette défaillance.

Une telle fonction peut être représentée sous la forme d'une table de vérité, d'équations booléennes, d'une table de Karnaugh. Ces divers modes de représentation connus permettent de visualiser chacune des combinaisons de variables (ou d'événements) qui peuvent exister. Cependant, ces représentations présentent l'inconvénient d'avoir une taille qui évolue exponentiellement en fonction du nombre de variables apparaissant dans la détermination de la fonction. Ainsi, pour une fonction dépendant de n variables, il existe une possibilité de $2^n$ combinaisons de ces variables.

En conséquence, si par exemple, la fonction est représentée sous la forme d'un tableau de vérité, chaque combinaison possible de variables et chaque valeur correspondante de la fonction peuvent être représentées sur une même ligne de sorte que, pour une fonction de n variables, un tel tableau comprend n + 1 colonnes et $2^n$ lignes. Il peut être stocké dans la mémoire d'une machine de traitement, mais occupe une place importante. De plus, pour déterminer la valeur de la fonction, pour une combinaison donnée des variables, il peut être nécessaire de parcourir un certain nombre de lignes du tableau, ce qui peut être préjudiciable aux temps de traitement. En supposant par exemple que la combinaison que l'on recherche soit la dernière apparaissant dans le tableau, il faudrait parcourir l'ensemble des lignes du tableau pour trouver la valeur correspondante de la fonction.

Afin de remédier aux inconvénients de ces représentations, il a été envisagé de représenter les fonctions booléennes sous la forme de graphes, ou diagrammes, de décision binaire, encore appelés B.D.D., initiales de leur appellation anglaise "Binary Decision Diagram".

Avant de rappeler ce qu'est un diagramme de décision binaire, il convient de rappeler quelques notions et définitions relatives aux fonctions, et la terminologie employée.

Supposons une fonction f définie par la formule suivante: $f = x_1 x_2{}^* + x_1{}^* x_2 x_3$. On dit que la formule est une formule propositionnelle, et que $x_1$, $x_2$, $x_3$ sont des variables propositionnelles, correspondant aux événements atomiques susceptibles de provoquer l'apparition d'un événement de référence.

Ainsi, dans l'analyse de défaillances de systèmes, les événements atomiques sont des causes de défaillance, et l'événement de référence est une défaillance particulière liée à ces causes combinées entre elles de certaines manières.

Les termes "$x_1$", "$x_2$", "$x_3$" et "$x_1{}^*$", "$x_2{}^*$", "$x_3{}^*$", qui apparaissent dans la formule sont des littéraux correspondant aux variables propositionnelles $x_1$, $x_2$, $x_3$.

Un littéral représente comment la variable propositionnelle intervient dans la fonction, c'est-à-dire si la survenance ou la non survenance de l'événement associé est décisive ou indifférente. $x_1 x_2{}^*$ et $x_1{}^* x_2 x_3$ sont des produits de littéraux. Un produit est donc une conjonction de variables et de négations de variables.

Le premier produit $x_1 x_2{}^*$ signifie que la présence ou l'absence de la troisième variable $x_3$ est indifférente.

La formule signifie que l'événement de référence survient (f=1) quand simultanément le premier événement atomique $x_1$ survient (x1=1) et le second $x_2$ ne survient pas ($x_2$=0), ou bien quand simultanément le premier événement $x_1$ ne survient pas et les second et troisième $x_2$ et $x_3$ surviennent.

Un graphe de décision binaire est constitué d'un certain nombre de labels, encore appelés étiquettes, reliés entre eux par des branches. Chaque label représente une variable déterminée de la fonction, d'où partent deux branches. L'ensemble constitué par un label, donc une variable, et les deux branches qui en partent constitue un noeud, parfois appelé vertex. Chaque branche peut être soit une branche terminale, qui aboutit sur une feuille terminale de valeur "0" ou "1", ou une branche intermédiaire qui aboutit sur le label d'un autre noeud. L'une des branches qui part d'un label est appelée la branche basse ou négative et représente ce qui se passe lorsque la valeur de la variable associée est "0" (en utilisant les conventions rappelées ci-avant), alors que l'autre branche, appelée la branche haute ou positive montre ce qui se passe lorsque la valeur de la variable est "1". En fait, l'arbre débute par une variable (un label) racine unique, appelée la racine, d'ou partent deux branches auxquelles sont reliées en cascade d'autres noeuds ou des feuilles.

En parcourant l'arbre depuis la racine jusqu'à une feuille terminale de valeur 1, on détermine une combinaison de littéraux, pour laquelle la fonction vaut 1, c'est-à-dire qu'on reconstitue une combinaison (un produit) de variables provoquant l'apparition de l'événement de référence représenté. En conséquence, en effectuant chacun des parcours depuis la racine jusqu'à chacune des feuilles terminales de valeur 1, on détermine chacune des combinaisons de variables provoquant l'apparition de l'événement de référence.

Un tel diagramme ou graphe permet donc de visualiser l'ensemble des combinaisons de variables d'une fonction, de façon extrêmement complète et concise. La place mémoire occupée est moindre par rapport aux tableaux, et les temps de traitement des fonctions représentées sous forme de graphes de décision binaire sont beaucoup plus rapides.

De plus, un graphe de décision binaire se prête tout particulièrement à un traitement automatique à l'aide d'un appareil de traitement puisque chaque noeud peut être représenté à l'aide d'informations contenues dans un mot mémoire de l'appareil.

Différentes approches des diagrammes de décision binaire ont été envisagées. Ainsi Randal E. Bryant, dans une publication parue dans "IEEE Transactions on Computers", Volume C-35, numéro 8, Août 1986, a montré comment on pouvait ordonner les variables et donc les noeuds, pour aboutir à des graphes extrêmement compacts mais parfaitement représentatifs des différentes combinaisons de variables apparaissant dans une fonction.

Cependant, de tels graphes ne permettent pas de faire efficacement ou rapidement toutes les manipulations possibles sur les fonctions ainsi représentées. En effet, certains types d'analyses nécessitent un calcul des impliquants premiers de la fonction: c'est par exemple le cas lorsqu'il s'agit de faire des études de probabilité et de survenance de l'événement racine, ou tout autre type d'analyse événementielle.

On rappelle qu'un impliquant d'une fonction est un produit qui implique cette fonction. On rappelle encore qu'un premier produit P "contient" un second produit P', si la relation P "implique" P' (ceci s'écrit P=>P' ) est vraie, et enfin un impliquant premier est un impliquant tel qu'il n'existe pas d'autre impliquant qui le contienne.

Le parcours d'un diagramme de décision binaire, à partir de sa racine jusqu'aux feuilles terminales ne permet pas de déterminer directement quels sont les impliquants premiers de cette fonction.

De récentes approches ont été envisagées pour calculer de façon implicite les impliquants premiers d'une fonction, à partir du diagramme de décision binaire qui la représente.

Ainsi, dans une publication faite en Novembre 1991, par la demanderesse, et dont les auteurs sont les inventeurs mentionnés dans la présente demande, plusieurs méthodes ont été présentées qui permettent de déterminer, de façon implicite, les impliquants premiers d'une fonction.

Ces méthodes consistent à transformer le diagramme de décision binaire, en utilisant des règles déterminées par les auteurs, et en représentant chaque littéral associé à une variable propositionnelle telle que $X_n$ apparaissant dans un produit par un jeu de deux autres variables, une première variable dite variable d'occurrence $O_n$ et une seconde variable, dite de signe $S_n$.

La représentation est simple: si la variable d'occurrence associée est nulle, ceci signifie que la variable propositionnelle est indifférente dans l'obtention du produit; dans ce cas la valeur de la variable de signe associée est indifférente; si la variable d'occurrence est positive ou de valeur binaire "1", ceci signifie que la présence ou l'absence de la variable propositionnelle associée est significative pour le résultat, et c'est la variable de signe associée qui indique si la variable propositionnelle correspondante est présente (par convention, la variable de signe =1 dans ce cas) ou absente (par convention, la variable de signe =0).

Les règles développées dans cette publication tiennent compte du fait qu'un même produit de variables peut posséder plusieurs représentations, et ont introduit la notion de "méta-produit".

En effet, pour n=4 par exemple, le produit $\{x_2.x_3{}^*.x_4\}$ peut être représenté par l'ensemble suivant de deux jeux de variables d'occurence et de signe [(0111),(1101)] et [(0111),(0101)] qui donnent une représentation canonique du produit.

En conséquence, un ensemble de produits différents peut être représenté par un premier ensemble de couples de référence. En faisant l'union logique de tous les couples de cet ensemble, on obtient un second ensemble de couples constituant le "méta-produit" qui est donc la représentation canonique de l'ensemble de produits.

Ainsi, en constituant, avec des règles déterminées, un diagramme ayant l'apparence d'un diagramme de décision binaire, utilisant des variables d'occurrence et de signe, on aboutit à une représentation implicite de l'ensemble des impliquants premiers: chaque parcours partant d'un label racine, et aboutissant sur une feuille terminale de valeur logique "1" passe tantôt par des branches positives associées à des variables d'occurrence, tantôt par leurs branches négatives, tantôt par des branches positives associées à des variables de signes, tantôt par leurs branches négatives. Le passage par la branche négative d'une variable d'occurrence ($O_i$) donnée lors d'un parcours, signifie que la variable propositionnelle correspondante ne participe pas au produit constituant l'impliquant premier considéré.

Cependant, les règles mises en évidence dans cette publication ne sont pas pour autant les mieux adaptées pour une exploitation automatique.

En effet, le calcul des impliquants premiers d'une fonction représentée sous la forme d'un diagramme de décision binaire comprenant une variable racine d'où partent une branche basse et une branche haute, elles-mêmes constituées de sous-branches basses et sous-branches hautes, nécessite un calcul des impliquants premiers de la branche basse, un calcul des impliquants premiers de la branche haute, et un calcul des impliquants premiers de la fonction représentant l'intersection de la branche basse et de la branche haute. Ensuite, le calcul final nécessite une opération ensembliste combinant les impliquants premiers ainsi calculés. Ceci suppose donc des calculs récursifs en parallèle car, pour aboutir aux impliquants premiers d'une branche principale, il faut avoir calculé puis combiné entre eux l'ensemble des impliquants premiers de chacune de ses sous-branches.

Les combinaisons ensemblistes (union, intersection, complémentation, etc...) nécessaires pour ces déterminations successives s'effectuent sans problème si les différentes branches et sous-branches possèdent une structure symétrique les unes par rapport aux autres. Si l'ordonnancement n'est pas correctement réalisé, on ne parvient pas à réaliser ces combinaisons nécessaires.

Or, la nécessité d'ordonnancer symétriquement les variables rend cette méthode extrêmement consommatrice de mémoire et difficile à réaliser automatiquement. On obtient parfois des représentations implicites intermédiaires de taille considérable, pour garder la symétrie, de sorte que la mémoire de la machine peut être saturée avant que l'ensemble des calculs soit terminé; de plus, même si la mémoire est suffisante, la représentation finale possède une taille très importante avec soit des informations redondantes, soit des informations non nécessaires pour la détermination des impliquants premiers.

Dans la mesure où la mémoire de l'appareil a été suffisante pour établir la représentation implicite des impliquants premiers, on peut toujours envisager de simplifier cette dernière, pour supprimer les redondances. Ceci est difficilement réalisable, voire impossible dans certains cas.

Les buts de l'invention sont donc de proposer un procédé de détermination implicite des impliquants premiers d'une fonction à partir de son diagramme de décision binaire, constitué dans la mémoire d'une machine de traitement, qui ne présente pas les inconvénients de l'art antérieur.

L'invention consiste en un procédé tel que défini par la revendication 1.

La normalisation consiste en fait à tester, et/ou à comparer, les valeurs des paramètres ou éléments intervenant dans la constitution des formes intermédiaires, et, selon les résultats des tests ou comparaisons, à constituer des formes intermédiaires simplifiées avant qu'elles soient construites. Cette façon d'agir évite d'encombrer la mémoire. Néammoins, elle entraine, dans certains cas, une perte de symétrie entre les formes intermédiaires, de sorte que les constructions ultérieures nécessitent la mise en oeuvre de fonctions spécifiques pour combiner ces formes intermédiaires.

L'invention est donc particulièrement avantageuse, puisqu'elle permet de construire une structure, ayant la forme d'un diagramme de décision binaire qui, en fait, donne une représentation implicite des impliquants premiers ne contenant que les éléments nécessaires à déterminer ces impliquants, réduisant la consommation de mémoire. La détermination s'effectue en parcourant les différentes trajets, partant de la variable racine de la structure ainsi constituée, et aboutissant à une feuille terminale dont la valeur est "1".

D'autres caractéristiques et avantages apparaîtront à la lecture de la description qui va suivre, faite en regard des figures annexées sur lesquelles:

- La figure 1 représente, de manière schématique, un diagramme de décision binaire d'une fonction booléenne (f);

- La figure 2 illustre la façon dont la mémoire d'un appareil de traitement peut être organisée, pour contenir des informations contenant le diagramme de la figure 1;

- La figure 3 illustre la fonction de normalisation d'un élément intermédiaire;

- Les figures 4 à 9 illustrent schématiquement diverses étapes de constitution de la représentation implicite des impliquants premiers de la fonction (f) de la figure 1;

- La figure 10 illustre la façon dont la mémoire d'un appareil de traitement peut être organisée, pour contenir des informations contenant le diagramme de la figure 9.

Ainsi qu'il a été évoqué, une variable propositionnelle peut être représentée à l'aide d'un jeu de variables d'occurrence et de signe associées.

On considèrera donc par la suite qu'à une variable propositionnelle $x_n$ on peut associer une variable d'occurrence $O_n$ et une variable de signe $s_n$.

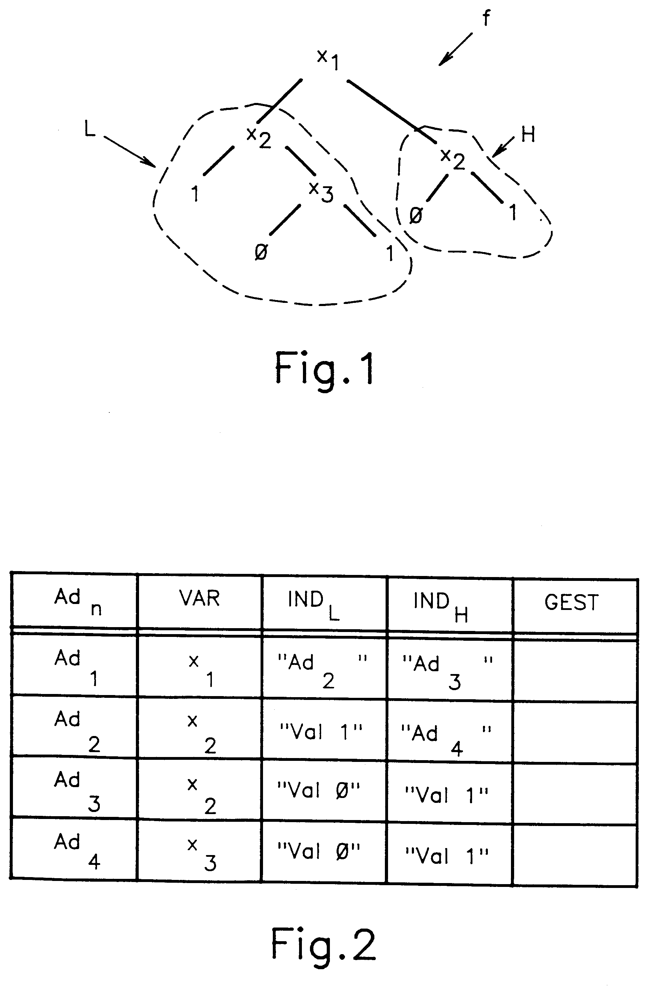

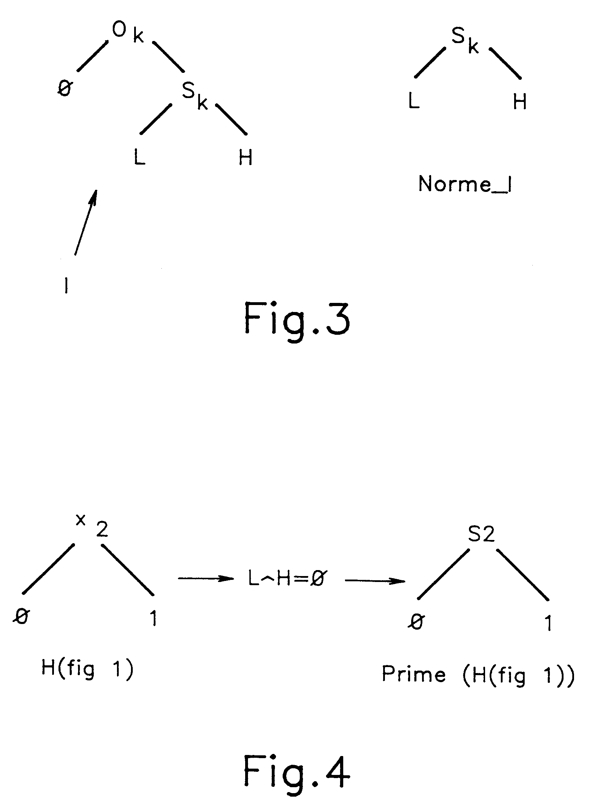

Sur la figure 1, on a représenté un diagramme de décision binaire d'une fonction dans laquelle apparaissent trois variables propositionnelles $x_1$, $x_2$, $x_3$.

Dans l'exemple illustré sur cette figure 1, une première variable, identifiée par un label $x_1$, est la racine du graphe. De cette variable partent deux branches, une première branche en bas à gauche et une seconde branche en bas à droite. La branche de gauche est appelée la branche basse, alors que la branche droite est appelée la branche haute. L'ensemble racine, branches basse et haute constitue donc un premier noeud du diagramme.

La branche basse et la branche haute aboutissent chacune sur une seconde variable identifiée par un label

$x_2$. A cette seconde variable est également associée une branche basse et une branche haute, ce qui constitue un autre noeud.

L'ensemble de labels (ou de variables), de branches, de feuilles associé à une branche basse d'une autre variable constitue ce que l'on appellera par la suite la partie basse notée L de cette variable. L'ensemble associé à la branche haute d'une variable constitue la partie haute, notée H de cette variable.

Ainsi, la partie haute de la variable $x_1$ débute par un noeud dont la racine est la variable $x_2$, la partie basse est la feuille 0 et la partie haute une feuille de valeur 1.

En parcourant les branches de l'arbre à partir de la racine en direction des feuilles de valeur "1", on détermine que la fonction représentée vaut 1 lorsque:

- $x_2$ vaut 0 et simultanément $x_1$ vaut 0, ou bien;
- $x_1$ vaut 0, et simultanément $x_2$ vaut 1 alors que $x_3$ vaut 1.

Ce qui précède se déduit du parcours des branches basses associées à la racine $x_1$.

Par ailleurs, de la partie haute associée à la racine $x_1$, on déduit que la fonction vaut également 1 lorsque simultanément $x_1$ et $x_2$ valent 1.

En conséquence de ce qui précède, la fonction représentée pourrait s'écrire $f = x_1{}^* x_2{}^* + x_1{}^* x_2 x_3 + x_1 x_2$.

La construction d'un diagramme de décision binaire, tel qu'il est présenté à la figure 1, répond à des règles déterminées et connues qui ne sont pas l'objet de la présente invention. Elles ont été décrites dans la publication mentionnée de Randal E. Bryant.

On constate qu'il existe une certaine symétrie entre les parties haute et basse associées à une variable, symétrie qui permet de faire des opérations logiques entre ces parties haute et basse sans difficulté. On constatera par la suite que la détermination implicite des implicants premiers d'une fonction représentée par un tel diagramme de décision binaire nécessite ce type d'opération.

La figure 2 illustre comment la mémoire d'un calculateur peut être organisée, pour contenir des informations constituant le diagramme de décision binaire de la fonction représentée sur la figure 1. Ceci n'est absolument pas limitatif.

De façon connue, la mémoire est organisée en mots, et chaque mot est déterminé par son adresse absolue ou relative ADn.

Afin de représenter un diagramme de décision binaire, chaque mot peut être divisé en au moins 4 champs, un premier champ VAR, un second champ $IND_L$, un troisième champ $IND_H$, et enfin un quatrième champ GEST.

Le premier champ VAR d'un mot contient une information indiquant la nature et le rang d'une variable propositionnelle de la fonction, par exemple $x_n$.

Le second champ $IND_L$ indique si la branche basse de la variable correspondante aboutit sur un noeud ou sur une feuille.

Le troisième champ $IND_H$ indique si la partie haute de la variable correspondante aboutit sur une feuille ou sur un noeud.

Le quatrième champ GEST contient par exemple des paramètres de gestion nécessaires pour l'exploitation de la mémoire, lorsque des parcours sont effectués entre les différentes adresses.

Plus précisément, le second et le troisième champs peuvent être complétés de la façon suivante: si la branche basse associée à la variable propositionnelle contenue dans le mot aboutit sur une feuille, alors ce second champ contient une indication "Val 0" ou "Val 1" de la valeur de cette feuille comme représenté dans certaines cases de cette figure 2.

Par contre, si la branche basse associée à une variable propositionnelle aboutit sur un noeud, alors ce second champ $IND_L$ contient la valeur de l'adresse mémoire du mot où est inscrit ce noeud.

Le troisième champ $IND_H$ indique, de la même manière que le second champ, si la branche haute associée à une variable aboutit sur un noeud ou sur une feuille et contient le cas échéant une adresse, ou une valeur.

Le quatrième champ GEST contient des paramètres de gestion indiquant les parcours qui ont déjà été effectués, ou tout autre type d'information nécessaire à la gestion et l'exploitation de cette mémoire.

Ainsi, en partant du mot situé à l'adresse AD1, et en parcourant l'ensemble de la mémoire, le système de traitement peut reconstituer les produits pour lesquels la fonction vaut "1". Il est donc en mesure de reconstituer l'arbre et ses différents noeuds.

Cependant, on remarque que, soit le parcours du diagramme de décision binaire, soit le parcours de la mémoire ne permet pas de déterminer les implicants premiers de la fonction. Conformément à la présente invention, à partir du diagramme de décision binaire d'une fonction booléenne, on élabore un diagramme qui représente de façon implicite les implicants premiers de la fonction.

Pour la clarté de l'exposé, on considèrera que le diagramme de décision binaire utilise des variables ($x_1$,...,

$x_n$) et le diagramme de ses impliquants premiers utilise les variables d'occurrence ($O_1,...,O_n$) et de signe ($S_1,...,S_n$) correspondantes.

On supposera aussi que les variables sont ordonnées de la façon suivante:

$$x_1 < x_2 <... < x_n \text{ et } O_1 < S_1 < O_2 < S_2 <...< O_n < S_n.$$

La transformation qui est mise en oeuvre pour déterminer le diagramme de représentation implicite des impliquants premiers conduit à construire des noeuds.

Par convention, dans la suite de la description, une formule du genre $y=Nd(x,L,H)$ signifie que le système de traitement construit dans sa mémoire le noeud identifié par la variable y, noeud dont le label est la variable x, la branche gauche, c'est-à-dire la branche basse, est L, et dont la branche droite, c'est-à-dire la branche haute, est H.

Par convention également, une formule du genre $Nd(x,L,H)=y$ décompose le noeud y en sa racine, c'est-à-dire la variable x, en sa branche gauche L et en sa branche droite H.

Le système de traitement réalise les opérations suivantes lors de la création d'un noeud.

Tout d'abord il teste, lors de l'élaboration du noeud y, si la branche basse L est égale à la branche haute H. Dans l'affirmative, au lieu de construire le noeud dont la racine serait x et les branches basse et haute respectivement L et H, il retourne simplement l'une de ces branches constituée par L (ou par H). Il peut bien entendu s'agir d'une feuille terminale (quand L=H=0 ou 1), ou autrement d'un noeud ou d'un ensemble de noeuds.

Dans le cas où L est différent de H, le système vérifie dans la mémoire, si le noeud en construction y existe déjà. Dans l'affirmative, il retourne directement ce noeud, en pointant sur son adresse en mémoire.

Si le noeud n'existe pas dans la mémoire, alors il y est construit, à une adresse laissée libre, de la façon indiquée auparavant.

Cette façon d'agir, qui consiste à ne pas reconstruire dans la mémoire un noeud qui y existe déjà, permet une économie de mémoire, et un gain de temps lors de l'exploitation ultérieure.

La fonction qui permet de construire la représentation implicite des impliquants premiers à partir du diagramme de décision binaire, c'est-à-dire une structure possédant des variables $x_1,..., x_n$, d'une fonction booléenne (f) est appelée PRIME(f). Cette fonction PRIME(f) permet d'obtenir une représentation constituée exclusivement de variables d'occurrence $O_1,...,O_n$ et de signe $S_1,...,S_n$.

Un test est d'abord réalisé pour déterminer la nature de la fonction.

Si f=0 alors PRIME(f)=0, si f=1 alors PRIME(f)=1;

Sinon, (f est différent de 0 ou de 1) ce qui signifie que f se présente sous la forme d'un noeud ayant une racine $x_k$, une branche basse L et une branche haute H. Donc, en utilisant les conventions précédemment définies, on peut écrire que $Nd(x_k,L,H)=f$.

Dans ce cas, la fonction PRIME, dont on remarquera plus loin qu'elle est récursive, fait appel à une fonction NORME qui normalise un noeud $Nd(O_k,P,P')$, dont la racine serait la variable d'occurrence $O_k$ associée à la variable racine $x_k$ du diagramme de décision binaire correspondant, la branche basse une représentation implicite P construite lors d'une récursion précédente, et la branche haute une autre représentation implicite P' construite à l'aide d'éléments obtenus lors d'une récursion précédente, comme il sera expliqué ci-après. Ainsi, on peut écrire:
$PRIME(f)=NORME(O_k,P, P')$

Dans un mode de mise en oeuvre préféré, la fonction NORME ($O_k$, P,P') dans lequel $O_k$ est une variable, P et p' sont des représentations implicites, débute par des tests successifs sur les valeurs de P et P', dont on rappelle qu'elles sont obtenues lors de récursions précédentes.

Si P=P' ou P'=0, alors le résultat final est $NORME(O_k,P, P')=P$. Si P=0, la fonction NORME permet de rendre le résultat $NORME(O_k,P, P')=P'$.

Si aucune des conditions précédentes sur P et P' n'est vérifiée, le résultat est un noeud défini de la façon suivante: $NORME(O_k,P, P')=N_d(O_k,P, P')$.

Le noeud normalisé n'est donc construit en mémoire qu'après que la détermination des valeurs relatives de P et P' a été effectuée, ce qui est particulièrement économique sur le plan de la consommation de mémoire, et rapide sur le plan du traitement.

La figure 3 illustre comment la fonction NORME agit. La partie gauche de la figure représente un noeud qui pourrait être obtenu si cette fonction n'était pas mise en oeuvre. Par exemple, la racine serait une variable d'occurrence $O_k$, reliée par sa branche basse à une feuille terminale de valeur 0, et par sa branche haute à un noeud dont la racine est $S_k$, la branche basse L et la branche haute H. La fonction NORME, appelée par la fonction prime appliquée à ce diagramme permet d'obtenir en définitive un noeud, représenté sur la partie droite de cette figure 3, dont la racine est la variable de signe $S_k$ et qui comporte une branche basse L et une branche haute H, sans que la représentation de la partie gauche soit construite en mémoire.

Il en aurait été de même si à la place de la branche basse de la partie gauche, reliée à une feuille de valeur "0", on avait eu un noeud $v=N_d(S_k,L,H)$ identique à celui de la branche haute.

Dans une première variante, un seul test sur les valeurs de P et P' est réalisé. Si le résultat de ce test est négatif, alors la fonction norme rend le résultat suivant:

$$\text{NORME}(O_k, P, P') = N_d(O_k, P, P').$$

Ainsi, dans une première mise en oeuvre de cette variante, le test est réalisé pour savoir si P=P' : dans l'affirmative, le résultat rendu est $\text{NORME}(O_k, P, P')=P$, sinon $\text{NORME}(O_k, P, P')=N_d(O_k, P, P')$.

Dans une seconde mise en oeuvre de cette variante, le test est réalisé pour savoir si P'=0: dans l'affirmative, le résultat rendu est $\text{NORME}(O_k, P, P')=P$, sinon $\text{NORME}(O_k, P, P')=Nd(O_k, P, P')$.

Dans une troisième mise en oeuvre de cette variante, le test est réalisé pour savoir si P=0: dans l'affirmative, le résultat rendu est $\text{NORME}(O_k, P, P')=P'$, sinon $\text{NORME}(O_k, P, P')=Nd(O_k, P, P')$.

D'autres variantes sont envisageables, dans lesquelles une première condition sur P et P' serait testée, en rendant le résultat approprié si cette première condition était vérifiée, puis une seconde au cas ou la première ne serait pas vérifiée, avant de rendre le résultat $\text{NORME}(O_k, P, P')=Nd(O_k, P, P')$, si la seconde condition elle-même n'était également pas vérifiée.

Une séquence de tests mettant en oeuvre cette seconde variante pourrait être la suivante: le premier test serait par exemple réalisé pour savoir si P=P' : dans l'affirmative, le résultat rendu serait

$$\text{NORME}(O_k, P, P') = P;$$

sinon un second test serait par exemple réalisé pour savoir si P=0 : dans l'affirmative, le résultat rendu serait :

$$\text{NORME}(O_k, P, P') = P';$$

sinon, le résultat rendu serait :

$$\text{NORME}(O_k, P, P') = Nd(O_k, P, P')$$

Il est bien entendu que ces deux variantes sont moins performantes, dans la mesure où elles peuvent conduire à l'élaboration de structures qui auraient été normalisées si le mode de mise en oeuvre préféré avait été utilisé.

Néammoins ces variantes, qui permettent un gain de temps, sont applicables pour des graphes de taille réduite.

La branche basse P du noeud normalisé est définie de la façon suivante: $P=\text{PRIME}(L \wedge H)$, c'est-à-dire que P est lui-même obtenu, par récursion, en appliquant les règles actuellement décrites à l'intersection logique des branches basse L et haute H de la fonction f représentée par son diagramme de décision binaire. La branche basse P est donc constituée par la représentation implicite des impliquants premiers de cette intersection des deux parties haute et basse de la fonction.

La branche haute P' du noeud normalisé est constituée par un noeud défini de la façon suivante:

$$P' = Nd[S_k, \text{MINUS}\{\text{PRIME}(L), P\}, \text{MINUS}\{\text{PRIME}(H), P\}].$$

En définitive,

$$\text{PRIME}(f) = \text{NORME}(O_k, P, Nd[S_k, \text{MINUS}\{\text{PRIME}(L), P\}, \text{MINUS}\{\text{PRIME}(H), P\}])$$

MINUS est une fonction intermédiaire permettant de simplifier la forme obtenue, et de tenir compte des résultats obtenus suite à l'application de la fonction NORME, lors des récursions précédentes. Cette fonction sera définie plus loin.

On constate donc bien que P et P', auxquels s'applique la fonction NORME, nécessitent pour leur élaboration, la construction préalable d'un diagramme représentant de façon implicite les impliquants premiers PRIME(L) de la branche basse L de la fonction f, celle d'un diagramme représentant implicitement les impliquants premiers PRIME(H) de la branche haute H de la fonction, et enfin celle d'un diagramme représentant de façon implicite les impliquants premiers PRIME(L∧H) de l'intersection logique entre les branches haute et basse de la fonction.

La construction de ces diagrammes PRIME(L), PRIME(H), PRIME(L∧H), nécessite donc de parcourir le diagramme de décision binaire de la fonction f de façon récursive. Néanmoins, contrairement à ce qui se faisait dans l'art antérieur, cette méthode ne nécessite pas la construction de diagrammes intermédiaires, puisque les éléments construits lors des récursions sont immédiatement intégrés dans la structure grace à l'emploi des fonctions particulières NORME, et MINUS. Cette dernière va maintenant être décrite.

La fonction NORME s'applique à une représentation implicite structurée à partir de variables d'occurrence et de signe.

La fonction MINUS s'applique également à une représentation implicite obtenue initialement par application de la fonction PRIME à des branches haute, basse, ou à la combinaison des deux.

En conséquence, les éléments sur lesquels agit la fonction MINUS sont soit des noeuds, soit des variables de valeur 0 ou 1. Lorsqu'il s'agit de noeuds, leur racine est soit une variable d'occurrence, soit une variable de signe.

Le résultat de la fonction MINUS est une représentation implicite.

Cette fonction MINUS, appliquée à deux représentations implicites qui peuvent être nommées P et P' peut s'écrire MINUS(P,P') commence par un test pour déterminer les valeurs relatives de p et de P'.

Si P=P' , ou si P=0, le résultat de la fonction MINUS appliquée à P et P' est MINUS(P,P')=0.

Si P=1 ou P'=0 ou P'=1, le résultat de la fonction MINUS est MINUS(P, P')=P .

Si aucune des conditions vérifiées ci-dessus n'est réalisée, alors les noeuds P et P' sont décomposés en leur racine v,v', leur branche gauche ou basse L, L' et leur branche droite ou haute H, H', ce qui peut s'écrire, en utilisant les conventions définies auparavant: Nd(v,L,H)=P et Nd(v',L',H')=P'.

Un test est ensuite réalisé pour déterminer la nature et le rang des variables racine v et v' des deux noeuds P et P'. En effet, la fonction MINUS applique des règles différentes selon le résultat trouvé.

Si les deux variables racines v et v' sont des variables d'occurrence, c'est-à-dire si $v=O_k$ et $v'=O_{k'}$, un autre test est réalisé pour déterminer les rangs k et k'. Si k est inférieur à k', alors le résultat de la fonction MINUS appliquée à P et P' est le suivant:

$MINUS(P, P')=NORME(O_k,MINUS(L),P',H)$ , c'est-à-dire qu'on normalise un noeud dont la racine serait la variable $O_k$, c'est-à-dire la racine du premier noeud P pris en compte par la fonction MINUS; la branche gauche ou basse de ce noeud est le résultat de la fonction MINUS appliquée d'une part à la branche gauche L du premier noeud P pris en compte, et d'autre part au second noeud P'; la branche droite ou haute est la branche droite H du premier noeud P impliqué par la fonction MINUS. On constate donc que la fonction MINUS nécessite elle-même des calculs récursifs, puisque l'un des éléments résultant est lui-même obtenu par l'application de cette même fonction à des éléments intermédiaires.

Si k=k' , alors le résultat de la fonction MINUS est le résultat de la fonction NORME appliquée à un noeud construit comme suit: la racine de ce noeud est la variable $O_k$; sa branche gauche ou basse est le résultat de la fonction MINUS appliquée respectivement aux branches basses L, L' des noeuds P, P' impliqués par la fonction MINUS, et sa branche droite ou haute est le résultat d'une fonction MINUS2 appliquée aux branches hautes H, H' des deux noeuds P,P' impliqués par la fonction MINUS.

Cette fonction MINUS2 sera décrite ultérieurement. En conséquence, le résultat de la fonction MINUS peut s'écrire:

$$MINUS(P, P')=NORME[O_k,MINUS(L,L'),MINUS2(H,H')).$$

Si aucune des deux conditions testées ci-dessus pour k et k' n'est vérifiée, alors le résultat de la fonction MINUS appliquée à P et P' est obtenu en appliquant la fonction MINUS au premier noeud P impliqué par la fonction MINUS et à la branche basse L' du second noeud P' impliqué par la fonction MINUS, ce qui peut s'écrire:

$$MINUS(P, P')=MINUS(P, L').$$

Si les tests sur la nature des variables v et v' révèlent que v est une variable d'occurrence ($v=O_k$), et que v' est une variable de signe ($v'=S_{k'}$), alors on teste le rang de k et k'.

Si k est inférieur à k' alors on normalise un noeud dont la racine est $O_k$, c'est-à-dire la variable racine du premier noeud P impliqué par la fonction MINUS, dont la branche gauche ou basse est le résultat de la fonction MINUS appliquée respectivement à la branche gauche ou basse L du premier noeud P, et au second noeud P', et dont la branche haute ou droite est la branche haute H du premier noeud P.

Ceci peut s'écrire $MINUS(P, P')=NORME(O_k,MINUS(L,P'),H)$ .

Si les tests révèlent que k est égal k', alors on normalise un noeud dont la racine et la variable $O_k$ du premier noeud P impliqué par la fonction MINUS, dont la branche basse ou gauche est la branche basse L du premier noeud P et dont la branche haute est le résultat de la fonction MINUS2 appliquée à la branche haute H du premier noeud P, et au second noeud P'.

Ceci peut s'écrire $MINUS(P, P')=NORME(O_k,L,MINUS2(H,P'))$ .

Si les tests sur les rangs k et k' sont négatifs, alors le résultat de la fonction MINUS est le premier noeud P lui-même.

Ceci peut s'écrire $MINUS(P, P')=P$ .

Les tests sur la nature des variables v et v' peuvent révéler que v est une variable de signe ($v=S_k$) et que

v' est une variable d'occurrence ($v'= O_k'$), Dans ce cas, si le test révèle que k est inférieur à k', alors le résultat de la fonction MINUS est le premier noeud P impliqué par la fonction MINUS.

Ceci peut s'écrire MINUS(P, P')=P .

Si k=k' , alors le résultat de la fonction MINUS est la fonction MINUS2 appliquée respectivement au premier noeud P, et à la branche haute ou droite H' du second noeud P'.

Ceci peut s'écrire MINUS(P, P')=MINUS2(P, H') .

Si aucune des conditions sur k et k' n'est vérifiée, alors le résultat est obtenu en appliquant la fonction MINUS au premier noeud P, et à la branche gauche ou basse L' du second noeud P'.

Ceci peut s'écrire MINUS(P, P')=MINUS(P, L') .

Enfin les tests peuvent révéler que les variables racine v et y' des deux noeuds P et P' impliqués par la fonction MINUS sont des variables de signes ($v=S_k$ , $v'=S_k'$). Dans ce cas, si les tests sur la valeur de k et k' révèlent que k est égal à k', alors le résultat de la fonction MINUS est un noeud dont la variable racine est $S_k$, c'est-à-dire la racine de l'un ou l'autre des noeuds impliqués par la fonction MINUS, dont la branche gauche ou basse est le résultat de la fonction MINUS appliquée respectivement aux branche basses L, L' des deux noeuds P,P' impliqués et dont la branche haute ou droite est obtenue en appliquant la fonction MINUS aux branches hautes ou droites H,H' des deux noeuds P,P' impliqués respectivement.

Ceci peut s'écrire:

$$MINUS(P, P')=Nd[S_k,MINUS(K,L'),MINUS(H,H')].$$

Si la condition testée précédemment sur l'identité entre k et k' n'est pas vérifiée, alors le résultat de la fonction MINUS est le premier noeud P impliqué.

Ceci peut s'écrire: MINUS(P, P')=P .

On a vu précédemment que la fonction MINUS nécessitait parfois l'emploi d'une fonction appelée MINUS2, qui s'applique à des éléments qui sont eux-mêmes des représentations implicites.

Si on appelle ces éléments respectivement P et P', la fonction MINUS2 appliquée à ces éléments peut s'écrire: MINUS2(P,P').

Cette fonction débute par un test pour comparer P et P'. S'il s'avère que P est identique à P', alors le résultat de la fonction MINUS2 est la variable "0". Si l'égalité entre les deux noeuds P et P' impliqués dans la fonction MINUS2 n'est pas vérifiée, on décompose respectivement ces deux noeuds P et P' pour retrouver leur racine $S_k$, $S_{k'}$, leur branche gauche ou basse L, L' et leur branche haute ou droite H,H'. Ceci s'écrit: $Nd(S_k,L,H)=P$ et $Nd(S_{k'},L,H)=P'$ .

Le résultat de la fonction MINUS2 est alors un noeud dont la racine est la variable racine $S_k$ du premier noeud P, dont la branche basse ou gauche est le résultat de la fonction MINUS appliquée aux branches basse ou gauche L, L' de chacun des deux noeuds P, P' impliqués par cette fonction MINUS2, et dont la branche haute ou droite est le résultat de la fonction MINUS appliquée aux branches hautes H,H' de chacun des deux noeuds P,P' impliqués par la fonction MINUS2.

Ceci peut s'écrire:

$$MINUS2(P, P')=Nd[S_k,MINUS(L,L'),MINUS(H,H')].$$

Les fonction MINUS et MINUS2 permettent néammoins d'aboutir à des résultats extrêmement simplifiés, car la fonction MINUS tient compte de la nature et du rang des variables v et v' des représentations auxquelles elle s'applique. Les procédés de l'art antérieur n'avaient pas permis d'obtenir de telles simplifications.

Les figures 4 à 9 illustrent progressivement la façon dont la représentation implicite des impliquants premiers du diagramme de décision binaire de la figure 1 est élaborée.

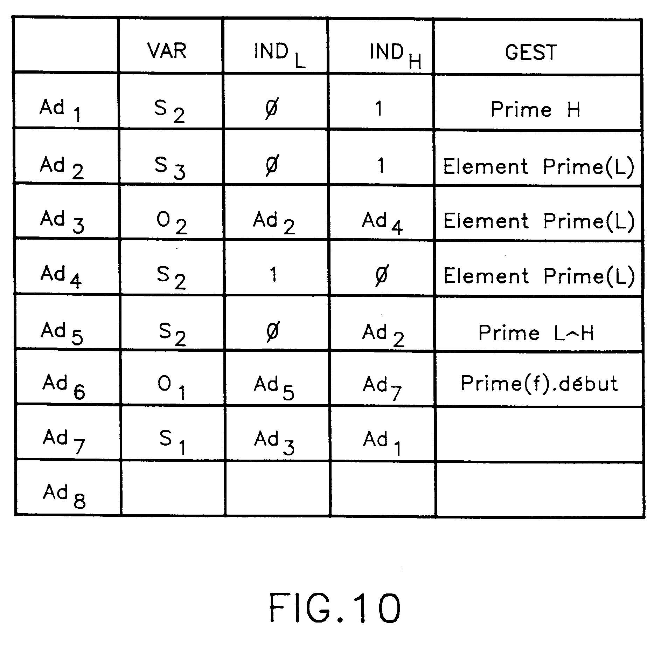

La figure 10 montre comment une mémoire d'un appareil de traitement pourrait être constituée à la fin des opérations de calcul, en supposant qu'on utilise une méthode comparable à celle décrite en regard de la figure 2.

L'observation de la fonction PRIME évoquée précédemment montre que pour élaborer la représentation implicite des impliquants premiers d'une fonction, elle-même représentée sous la forme d'un diagramme de décision binaire, il est nécessaire d'effectuer de façon récursive le calcul implicite des impliquants premiers de chacune des branches haute et basse de cette fonction.

Les règles de simplification résultant des fonctions NORME et MINUS permettent d'obtenir des représentations intermédiaires de taille raisonnable.

La figure 4 comporte trois dessins mis en correspondance les uns avec les autres à l'aide de flèches. La partie gauche de cette figure représente la branche haute H qui est entourée sur la figure 1. Cette branche haute est constituée par un noeud dont la variable racine est X2, dont la branche basse L est la variable 0 et la branche haute H est la variable 1. L'intersection logique L∧H des deux branches donne le résultat 0 dont la connaissance est nécessaire pour le calcul de la représentation implicite des impliquants premiers de cette branche. Après application de la fonction NORME, on obtient en définitive un noeud $Nd(S_2,0,1)$ qui est la représentation implicite des impliquants premiers de la partie haute du diagramme de décision binaire de la figure 1. Ce noeud est représenté à droite sur la figure 4.

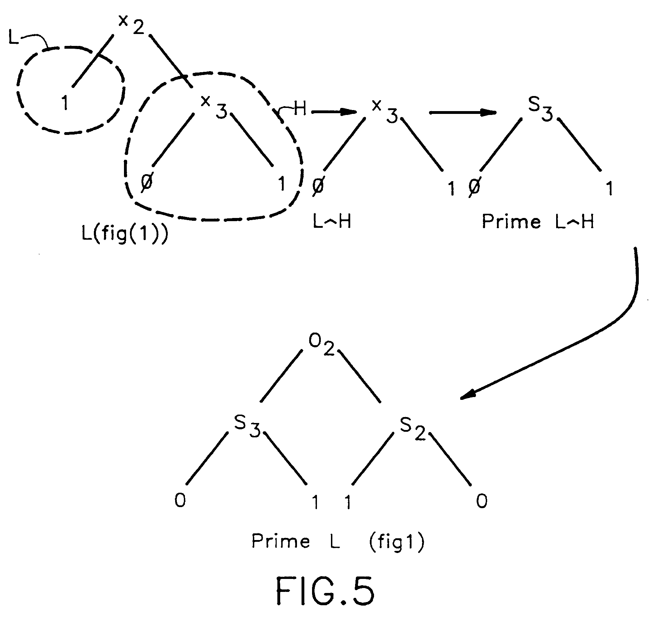

Sur la figure 5, on a représenté la partie basse L du diagramme de décision binaire de la figure 1. Cette partie basse comprend elle-même une partie basse L dont la valeur est la constante 1, et une partie haute H constituée par un noeud $Nd(X_3,0,1)$. Puisque la partie basse L est constituée par la constante de valeur 1, l'intersection L∧H entre la partie haute et la partie basse de cette figure redonne le noeud constituant la partie haute, c'est à dire que L∧H = $Nd(X_3,O,1)$.

On remarque que la structure de ce noeud est identique, au rang de son label racine près, à celui qui représente la branche haute de la figure 1. En conséquence, la représentation implicite de ses impliquants premiers est le noeud suivant: PRIME(L∧H)=$Nd(S_3,0,1)$.

En définitive, l'application de la fonction PRIME, qui fait intervenir les fonctions NORME, et MINUS, conduit à aboutir à la représentation implicite des impliquants premiers de la partie basse du diagramme de la figure 1, constituée ainsi:

$$PRIME(L_{(fig.1)})=Nd[O_2,Nd(S_3,0,1),Nd(S_2,1,0)],$$

et illustrée dans la partie inférieure de cette figure 5.

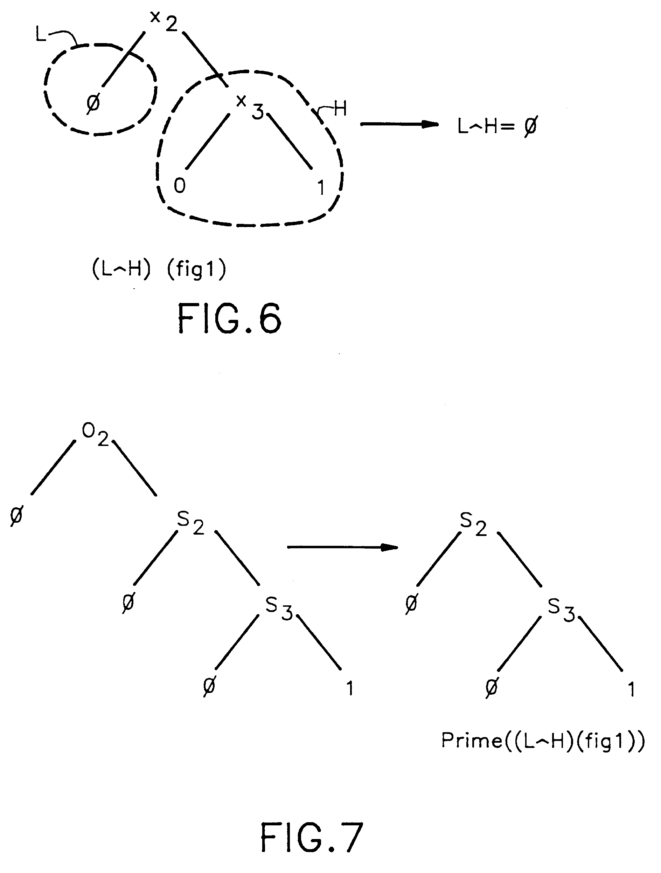

Sur la figure 6, on a représenté le diagramme représentatif de l'intersection des branches basse L et haute H de la figure 1. Il représente un noeud dont la racine est $X_2$, dont la branche basse est la constante 0, et dont la branche haute est un noeud $Nd(X_3,0,1)$. On constate que ce dernier est identique à la branche haute de la figure 5, ou à l'intersection des branches basse et haute de cette même figure 5. En conséquence, le système de traitement, en parcourant la mémoire, déterminera que le calcul de la représentation implicite de ses impliquants premiers a déjà été effectué et ne le réexécutera donc pas.

L'intersection logique des branches haute et basse des éléments de cette figure 6 aboutit à la constante 0.

En résultante, si la fonction NORME n'était pas appliquée, la représentation implicite des impliquants premiers des éléments de la figure 6 serait celle qui apparait sur la partie gauche de la figure 7. En raison de l'existence de cette fonction NORME, la représentation implicite des implicants premiers de l'intersection logique des branches haute et basse est le noeud qui apparait sur la partie droite de cette même figure 7, c'est à dire le noeud $Nd(S_2,0,Nd(S_3,0,1))$.

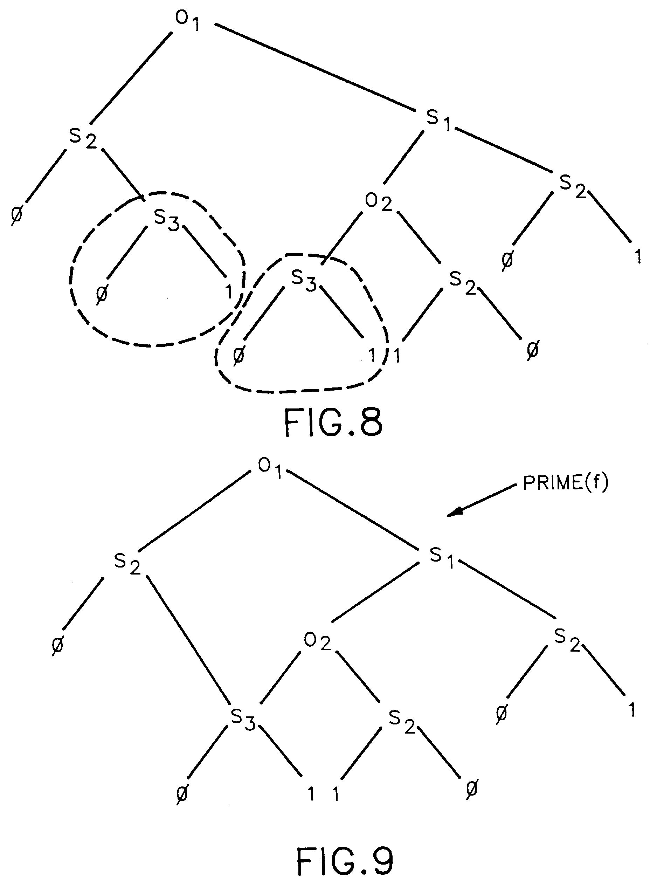

La figure 8 illustre une représentation intermédiaire implicite des impliquants premiers du diagramme de la figure 1, qui serait obtenue si aucun test n'était réalisé pour éviter la redondance entre des noeuds identiques pointés à partir de différents labels.

Le schéma de cette figure 8 résulte de l'application de la fonction PRIME aux représentations intermédiaires apparaissant sur les figures 4 à 7.

Ainsi, sur cette figure 8, la détermination du noeud constituant la branche basse associée à la variable $S_1$ aurait été obtenue après application des fonctions MINUS et MINUS2 à certains éléments des représentations intermédiaires.

Surtout, on remarque que cette représentation de la figure 8 utiliserait deux fois le noeud $Nd(S_3,0,1)$ qui a été entouré sur cette figure.

On constate en effet que ce noeud est associé d'une part à une branche basse reliée à un label $O_2$ et à une branche haute reliée à un label $S_2$. C'est pourquoi, au lieu de batir deux fois ce noeud, il n'est bati qu'une fois, de sorte qu'on aboutit à un schéma conforme à celui de la figure 9, où le label $S_3$ est pointé par deux variables différentes $O_2$, $S_2$.

On constate que la représentation de la figure 9 est comparable à celle de la figure 1, en ce sens qu'on obtient un diagramme ayant l'apparence d'un diagramme de décision binaire, c'est à dire bati à partir d'une racine $0_1$, dans le cas présent, et ayant des parcours aboutissant sur des feuilles terminales de valeur 0 ou 1.

En effectuant les différents parcours, en partant du noeud racine et en se dirigeant vers les feuilles de valeur 1, on détermine les impliquants premiers de la fonction associée.

Le gestionnaire de mémoire est agencé pour pointer les différents parcours effectués lors de la détermination des impliquants.

Ainsi, dans le cas particulier, on détermine quatre parcours différents constituant ainsi quatre produits représentant les impliquants premiers de la fonction.

Un premier parcours peut se lire comme suit: $O_1^*,S_2,S_3$, ce qui signifie que l'impliquant premier associé est le produit $X_2,X_3$, puisque la variable d'occurence $0_1$, négative, signifie que $X_1$ ne participe pas au produit. Un second parcours est $O_1,S_1^*,O_2^*,S_3$, ce qui signifie en définitive que l'impliquant premier associé est le produit $X_1^*,X_3$.

Un troisième parcours est $O_1,S_1^*,O_2,S_2^*$ ce qui signifie que l'impliquant premier associé est le produit $X_1^*,X_2^*$.

Enfin, un quatrième parcours est $O_1,S_1,S_2$ ce qui signifie que l'impliquant premier associé est $X_1,X_2$.

La figure 10 illustre comment une partie de mémoire destinée à recevoir des informations relatives à la représentation implicite des impliquants premiers de la fonction f donnée en exemple sur les figures 1 ou 2 pourrait être remplie.

On suppose que les règles de remplissage de la mémoire sont similaires à celles qui ont été évoquées en regard de la figure 2. Ainsi, chaque mot situé à une adresse $AD_n$ de cette zone de mémoire peut être décomposé en quatre champs, un premier champ VAR recevant des indications sur la nature et l'ordre de la variable qu'il contient, un second champ $IND_L$ indiquant soit l'adresse ou la valeur de la branche basse associée, un troisième champ $IND_H$ indiquant l'adresse ou la valeur de la branche haute associée, et enfin un quatrième champ GEST avec des paramètres de gestion de la mémoire, par exemple.

Ainsi, le mot situé à la première AD1 de cette zone mémoire contiendrait par exemple le noeud $Nd(S_2,0,1)$ correspondant à la représentation implicite des impliquants premiers de la partie haute H de la fonction de la figure 1. Ce noeud a été mis en évidence lors de la description de la figure 4.

Le second mot, d'adresse AD2 contiendrait un noeud $Nd(S_3,O,1)$ qui est celui qui a été mis en évidence à la figure 5.

Le troisième mot, à l'adresse AD3 contient des indications permettant de reconstruire le noeud donnant la représentation implicite des impliquants premiers de la partie basse de la fonction visualisée sur la figure 1. Ce noeud, dont la racine est $O_2$, a été mis en évidence avec la description de la figure 5. Sa branche basse est le noeud $Nd(S_3,0,1)$ dont la représentation se trouve déjà au deuxième mot, d'adresse AD2. En conséquence, le deuxième champ $IND_L$ de ce troisième mot contient une indication selon laquelle la branche basse est constituée par le mot d'adresse AD2, ce qui évite de reconstruire ce noeud existant déjà.

La partie haute, qui n'a pas encore été construite, puisqu'elle est constituée par un noeud $Nd(S_2,1,0)$ serait donc inscrite dans le mot d'adresse AD4 et une indication en ce sens serait portée dans le champ $IND_H$ du troisième mot, afin que le système pointe sur l'adresse AD4.

Le cinquième mot, d'adresse AD5 contiendrait des informations relatives à la représentation implicite des impliquants premiers prime(L/\H) de la fonction représentant l'intersection logique entre les parties haute et basse de la figure 1.

Cette dernière représentation implicite apparait sur la figure 7 : il s'agit d'un noeud dont la racine est la variable de signe $S_2$, la partie basse la constante 0 et la partie haute un noeud $Nd(S_3,0,1)$. Or, on constate que cette partie haute a déjà été construite: il s'agit du mot situé à l'adresse AD2. En conséquence, dans le mot d'adresse AD5, le système d'exploitation indiquerait que la variable racine est $S_2$, que la partie basse est constituée par la constante 0, en remplissant de façon appropriée le champ $IND_L$, et indiquerait dans le champ $IND_H$ qu'il faut pointer à l'adresse AD2 pour retrouver le noeud constituant cette partie haute.

Les sixième et septième mots situés respectivement aux adresses AD6 et AD7 contiennent des informations permettant de terminer la constitution de la représentation implicite qui apparaissait à la figure 9.

Le sixième mot contient dans son champ variable, la racine $O_1$ de la représentation implicite des impliquants premiers de la fonction de la figure 1. On constate que la partie basse associée à cette représentation implicite est constituée d'éléments qui ont déjà été inscrits dans la mémoire. Ces informations sont déjà contenues dans le cinquième mot qui a déjà été complété, de sorte qu'il n'est pas nécessaire de les répéter. Le champ $IND_L$ contient donc un renvoi à l'adresse AD5.

Le noeud dont le label est la racine de la partie haute de la représentation implicite n'a pas encore été totalement représenté, de sorte qu'il faut inscrire dans la mémoire, à l'adresse AD7 des informations relatives à cette partie haute. En conséquence, le champ $IDN_H$ du mot d'adresse AD6 envoie à l'adresse AD7. En conséquence, dans le mot situé à cette adresse AD7, on inscrit le label du noeud constituant cette partie haute, à savoir la variable $S_1$. Cependant, on constate que les parties basse et haute de ce noeud ont déjà été construites antérieurement: la partie basse est constituée par le noeud inscrit dans le troisième mot, d'adresse AD3. En conséquence, le champ $IND_L$ de ce septième mot contiendrait un envoi à cette adresse AD3.

On constate également que la partie haute du noeud en construction est constituée par le noeud d'adresse AD1 déjà construit.

Les paramètres du champ de gestion GEST indiquent par exemple si le noeud correspondant est la racine de la représentation implicite, ou bien un noeud intermédiaire. Il est bien entendu que le contenu de ce champ peut évoluer au fur et à mesure de l'élaboration du graphe, puisqu'à un moment donné, un noeud peut constituer la racine d'une représentation intermédiaire, et devenir par la suite un élément intermédiaire de la construction.

C'est donc le système de traitement qui gère ces paramètres, à l'aide de pointeurs, lors du remplissage de la mémoire.

Il est bien entendu que la représentation de la figure 10 n'est qu'un exemple, non limitatif, de la façon dont la mémoire peut être structurée pour donner une représentation implicite des impliquants premiers d'une fonction.

Ainsi, par exemple, dans une variante, non représentée, les paramètres de gestion puisqu'ils sont susceptibles d'évoluer, sont inscrits et gérés par le système de traitement dans une zone spécifique de mémoire au lieu d'être inscrits dans un champ associé à chaque mot.

D'autres variantes, concernant la gestion de la mémoire, sont à la portée de l'homme du métier.

Des essais, réalisés dans le cadre de la mise au point de la présente invention, ont permis d'obtenir des représentations implicites d'impliquants premiers occupant une place mémoire réduite d'un facteur vingt par rapport aux représentations obtenues avec les procédés de l'art antérieur. Il est significatif que plus le nombre de variables impliquées dans la définition du diagramme de décision binaire est élevé, meilleurs sont les gains relatifs par rapport à l'emploi des procédés de l'art antérieur. Ceci met donc en évidence tout l'intérêt de l'invention, puisque c'est lorsque les diagrammes de décision binaire sont de taille importante qu'il existe le plus grand risque de saturation de la mémoire, et qu'il convient d'employer des méthodes peu consommatrices de mémoire.

Les tableaux, dans les pages ci-après, en forme d'annexe, résument les fonctions PRIME, NORME, MINUS, MINUS2.

## **ANNEXE**

### **I. fonction PRIME(f)**

Dans PRIME(f), f est un diagramme de décision binaire et le résultat de cette fonction PRIME est une représentation implicite de ses impliquants premiers.

1) Si f=0, PRIME(f)=0;
2) Si f=1, PRIME(f)=1;

3) Sinon, $Nd(x_k,L,H)=f$ et $P=PRIME(L/\backslash H)$ dans la relation suivante qui détermine la règle de construction de la représentation implicite des impliquants premiers de la fonction représentée par son diagramme (f) de décision binaire:

$$PRIME(f)=NORME[O_k,P,Nd(S_k,MINUS\{PRIME(L),P\},$$
$$MINUS\{PRIME(H),P\})].$$

### **II. fonction NORME(x,P,P') (mise en oeuvre préférée)**

Dans NORME(x,P,P'), x est une variable, P et P' sont des représentations implicites.

1) Si P=P' ou P'=0, alors NORME(x,P,P')=P;
2) Si P=0, alors NORME(x,P,P')=P';
3) Sinon NORME(x,P,P')=Nd(x,P,P').

-------------------------------------------------------------------

## ANNEXE (suite)

### III. fonction MINUS(P,P')

MINUS(P,P'), dans laquelle P et P' sont des représentations implicites, rend une représentation implicite.

1) Si P=P' ou P=0, MINUS(P,P')=0;

2) Si P=1 ou P'=0 ou P'= 1, MINUS(P,P')=P;

3) Sinon, Nd(v,L,H)=P et Nd(v',L',H')=P', puis:

    A) Si $v=O_k$ et $v'=O_k'$

      1. Si k < k', alors:

        MINUS(P,P')=NORME($O_k$, MINUS(L,P'),H);

      2. Si k=k'

        MINUS(P,P')=NORME($O_k$, MINUS(L,L'), MINUS2(H,H'));

      3. Sinon:

        MINUS(P,P')=MINUS(P,L').

    B) Si $v=O_k$ et $v'=S_k'$

      1. Si k < k', alors:

        MINUS(P,P')=NORME($O_k$, MINUS(L,P'),H)';

      2. Si k=k', alors:

        MINUS(P,P')=NORME($O_k$,L,MINUS2(H,P'));

      3. Sinon: MINUS(P,P')=P

    C) Si $v=S_k$ et $v'=O_k'$

      1. Si k < k', alors:

        (MINUS(P,P')=P;

      2. Si k=k', alors:

        MINUS(P,P')=MINUS2(P,H');

      3. Sinon:

        MINUS(P,P')=MINUS(P,L').

    D). Si $v=S_k$ et $v'=S_k'$

      1. Si k=k', alors:

        MINUS(P,P')=Nd[$S_k$, MINUS(L,L'), MINUS(H,H')];

      2. Sinon

        MINUS(P,P')=P

**ANNEXE (suite)**

**IV. Fonction MINUS2**

MINUS2(P,P') dans laquelle P et P' sont des représentations implicites, rend une représentation implicite.

1) Si P=P', MINUS2(P,P')=0
2) Sinon Nd($S_k$,L,H)=P et Nd($S_k$',L',H')=P', puis:
MINUS2(P,P')=Nd[$S_k$, MINUS(L,L'), MINUS(H,H')].

-------------------------------------------------------

L'algorithme de la fonction MINUS qui a été présenté auparavant peut être présenté sous une version simplifiée.

1) Si P=P' ou P=O, MINUS(P,P')=0;
2) Si P=1 ou P'=0 ou P'=1, MINUS(P,P')=P;
3) Nd(V,L,H)=P et Nd (V',L',H')=P'

   A). Si k < k'
      i) Si v=$O_k$ (v est une variable d'occurrence)
        MINUS(P,P')=NORME[$O_k$, MINUS(L,P'),H];
      ii) Sinon: MINUS(P,P')=P
   B) Si k > k'
      i) Si v'=$O_k$' (v' est une variable d'occurrence),
        MINUS(P,P')=MINUS(P,L')
      ii) Sinon, MINUS(P,P')=P
   C) Si v=$O_k$ (v est une variable d'occurrence)
      i) Si v'=$O_k$', alors:
        MINUS(P,P')=NORME[$O_k$, MINUS(L,L'), MINUS2(H,H')];
      ii) Sinon MINUS(P,P')=NORME[$O_k$, L, MINUS2(H,P')];
   D) Sinon
      i) Si v'=$O_k$'
        MINUS(P,P')=MINUS2(P,H');
      ii) Sinon:
      MINUS(P,P')=Nd[$S_k$,MINUS(L,L'),MINUS(H,H')].

**Revendications**

1. Procédé d'élaboration automatique, à l'aide d'un appareil de traitement de données, dans une zone mémoire de cet appareil, d'une représentation implicite (PRIME(f)) des impliquants premiers d'une fonction booléenne initialement représentée, dans une autre zone mémoire de cet appareil, sous la forme d'un diagramme de décision binaire (f) de cette fonction, consistant à élaborer la représentation implicite à partir des informations constituant le diagramme de décision, en effectuant des parcours récursifs au travers de ce diagramme pour déterminer des éléments intermédiaires ensuite combinés entre eux suite à chaque récursion, chaque élément intermédiaire utilisant des variables d'occurence ($O_1$,...,$O_n$) et des variables de signe ($S_1$,...,$S_n$), correspondant respectivement à chacune des variables propositionnelles ($x_1$,..., $x_n$) du diagramme de décision, caractérisé en ce qu'il consiste à construire en mémoire, pour chaque noeud qui n'existe pas déjà en mémoire et dont la racine est la variable d'occurrence $O_k$ associée à la variable racine $x_k$, du diagramme de décision binaire correspondant, un élément intermédiaire normalisé lors de son élaboration selon les valeurs relatives de la branche basse de ladite racine, consistant en une représentation implicite P construite lors d'une récursion précédente, et de la branche haute de ladite racine, consistant en une autre représentation implicite P' construite à l'aide d'éléments obtenus lors d'une récursion précédente.

2. Procédé selon la revendication 1, caractérisé en ce que le diagramme de décision binaire de la fonction booléenne constituant, de façon connue, un noeud $Nd(x_k,L,H)$, dans lequel $x_k$ est un label ou une variable racine, L est la branche basse associée à ce label, H est la branche haute associée à ce label, il consiste, pour obtenir la représentation implicite des impliquants premiers de la fonction:

   - à décomposer le noeud en sa branche basse L, en sa branche haute H,
   - à obtenir une représentation implicite normalisée des impliquants premiers de chacune de ces branches;
   - à déterminer le diagramme de décision binaire (L∧H) associé à l'intersection logique des deux branches;
   - - à obtenir une représentation implicite normalisée des impliquants premiers de cette intersection
   - à combiner entre elles, selon une règle déterminée, les représentations implicites normalisées pour obtenir un résultat;
   - à normaliser ce résultat lors de son élaboration.

3. Procédé selon la revendication 2, caractérisé en ce que chaque branche (L, H) d'un noeud et leur intersection (L∧H) pouvant être constituées par une association de noeud, avec des labels ($x_i$) aboutissant finalement sur des feuilles terminales de valeur logique 0 ou 1, il consiste, pour obtenir les représentations implicites des impliquants premiers de ces branches ou de leurs intersections, à effectuer des parcours récursifs au travers de chacun des noeuds ainsi associés.

4. Procédé selon l'une des revendications 2 ou 3, caractérisé en ce que la représentation implicite (PRIME(f)) des impliquants premiers d'un premier noeud (f) dont la racine est $x_k$, la branche basse L, la branche haute H, est construite conformément à:

$$\text{PRIME(f)=NORME}[O_k,P, Nd(S_k,\text{MINUS}\{\text{PRIME(L)},P\}, \text{MINUS}\{\text{PRIME(H)},P\})],$$

qui obéit aux règles suivantes: PRIME(0)=0; PRIME(1)=1, et dans laquelle P=PRIME(L∧H) est un second noeud constituant la représentation implicite des impliquants premiers de l'intersection logique des branches basse L et haute H du noeud considéré;

   dans laquelle Nd("variable",A,B) élabore un noeud dont le label est l'élément "variable", la branche basse l'élément A, la branche haute l'élément B;
   dans laquelle, NORME est une fonction permettant d'obtenir une forme normalisée d'un noeud;
   et dans laquelle MINUS est une fonction qui, appliquée à deux formes normalisées, permet d'achever la représentation implicite.

5. Procédé selon la revendication 4, caractérisé en ce que la fonction NORME(x,P,P'), dans laquelle x est une variable, et P et P' sont deux représentations implicites, met en oeuvre des tests pour comparer ces deux représentations implicites et déterminer leur valeur, puis rend l'un ou l'autre des résultats normalisés suivants, selon le résultat des tests:

   Si P=P' ou P'=0, alors NORME(x,P, P')=P;

Si P=0, alors NORME(x,P, P')=P';

Sinon NORME(x,P,P')=Nd(x,P,P').

**6.** Procédé selon la revendication 4, caractérisé en ce que la fonction NORME(x,P,P'), dans laquelle x est une variable, et P et P' sont deux représentations implicites, met en oeuvre un premier test pour comparer ces deux représentations implicites et déterminer leur valeur, puis rend l'un ou l'autre des résultats normalisés suivants, selon le résultat du test:

Si P=P', alors NORME(x,P, P')=P;

Sinon NORME(x,P,P')=Nd(x,P,P').

**7.** Procédé selon la revendication 4, caractérisé en ce que la fonction NORME(x,P,P'), dans laquelle x est une variable, et P et P' sont deux représentations implicites, met en oeuvre un premier test pour comparer ces deux représentations implicites et déterminer leur valeur, puis rend l'un ou l'autre des résultats normalisés suivants, selon le résultat du test:

Si P=0, alors NORME(x,P, P')=P';

Sinon NORME(x,P,P')=Nd(x,P,P').

**8.** Procédé selon la revendication 4, caractérisé en ce que la fonction MINUS(P,P'), dans laquelle P et P' sont des représentations implicites, et qui rend une représentation implicite met en oeuvre un second test pour comparer ces deux représentations implicites et déterminer leur valeur, puis rend l'un ou l'autre des résultats suivants, selon le résultat du test:

Si P=P' ou (P=0), alors MINUS(P, P')=0;

Si P=1 ou P'=0 ou P'= 1, MINUS(P, P')=P.

**9.** Procédé selon la revendication 8, caractérisé en ce que lorsque le résultat du second test met en évidence le fait que P est différent de P' et que simultanément P et P' ne constituent pas des branches terminales, c'est-à-dire constituent deux noeuds distincts, la fonction MINUS consiste:

- à décomposer le noeud P en sa racine (v), sa branche basse L, sa branche haute H;
- à décomposer le noeud P' en sa racine (v'), sa branche basse L', sa branche haute H';
- à tester si les racines (v, v') sont des variables d'occurence ou de signe;
- à tester leur rang;
- puis, en fonction des résultats de ces deux derniers tests, à rendre les résultats suivants:

A) Si $v=O_k$ et $v'=O_{k'}$

1. Si k < k', alors:

$$MINUS(P, P')=NORME(O_k, MINUS(L,P'),H);$$

2. Si k=k'

$$MINUS(P, P')=NORME(O_k, MINUS(L,L'), MINUS2(H,H'));$$

3. Sinon:

$$MINUS(P, P')=MINUS(P, L').$$

B) Si $v=O_k$ et $v'=S_{k'}$

1. Si k < k', alors:

$$MINUS(P, P')=NORME(O_k, MINUS(L,P'),H);$$

2. Si k=k' , alors:

$$MINUS(P, P')=NORME(O_k,L,MINUS2(H,P'));$$

3. Sinon: $MINUS(P, P')=P$

C) Si $v=S_k$ et $v'=O_k$,

1. Si k < k', alors:

$$(MINUS (P, P')=P;$$

2. Si k=k' , alors:

$$MINUS(P, P')=MINUS2(P, H');$$

3. Sinon:

$$MINUS(P, P')=MINUS(P, L').$$

D). Si $v=S_k$ et $v'=S_k$,

1. Si k=k' , alors:

$$MINUS(P, P')=Nd[S_k, MINUS(L,L'), MINUS(H,H')];$$

2. Sinon

$$MINUS(P, P')=P.$$

**10.** Procédé selon la revendication 8, caractérisé en ce que lorsque le résultat du second test met en évidence le fait que P est différent de P' et que simultanément P et P' ne constituent pas des branches terminales, c'est-à-dire constituent deux noeuds distincts, la fonction MINUS consiste:

- à décomposer le noeud P en sa racine (v), sa branche basse L, sa branche haute H;
- à décomposer le noeud P' en sa racine (v'), sa branche basse L', sa branche haute H';
- à tester si les racines (v, v') sont des variables d'occurence ou de signe;
- à tester leur rang;
- puis, en fonction des résultats de ces deux derniers tests, à rendre les résultats suivants:

A). Si k < k'

i) Si $v=O_k$ (v est une variable d'occurrence)

$$MINUS(P, P')=NORME[O_k, MINUS(L,P'),H];$$

ii) Sinon: $MINUS(P, P')=P$

B) Si k > k'

i) Si $v'=O_k$, (v' est une variable d'occurrence),

$$MINUS(P, P')=MINUS(P, L')$$

ii) Sinon, $MINUS(P, P')=P$

C) Si $v=O_k$ (v est une variable d'occurrence)

    i) Si $v'=O_{k'}$ (v' est une variable d'occurrence), alors:

$$MINUS(P, P')=NORME[O_k, MINUS(L,L'), MINUS2(H,H')];$$

    ii) Sinon $MINUS(P, P')=NORME[O_k, L, MINUS2(H,P')]$ ;

D) Sinon

    i) Si $v'=O_{k'}$

$$MINUS(P, P')=MINUS2(P, H');$$

    ii) Sinon:

$$MINUS(P, P')=Nd[S_k, MINUS(L,L') , MINUS(H,H')].$$

**11.** Procédé selon l'une des revendications 9 ou 10, caractérisé en ce que la fonction MINUS2(P,P'), dans laquelle P et P' sont des représentations implicites, et qui rend une représentation implicite met en oeuvre un dernier test pour comparer ces deux représentations implicites puis, selon le résultat du test:

- si P=P', alors MINUS2(P,P')=0
- sinon le noeud P est décomposé en sa racine ($S_k$), sa branche basse L, sa branche haute H; le noeud P' est décomposé en sa racine ($S_{k'}$), sa branche basse L', sa branche haute H'; $Nd(S_k,L,H)=P$ et $Nd(S_{k'},L',H')=P'$ , puis:

$$MINUS2(P, P')=Nd[S_k, MINUS(L,L'), MINUS(H,H')].$$

**12.** Procédé selon l'une des revendications précédentes, caractérisé en ce que le système de traitement est agencé pour tester, suite à la détermination des paramètres d'un nouveau noeud, si ce noeud existe déjà en mémoire et, dans l'affirmative inscrire dans la mémoire des données permettant de réutiliser ce noeud déjà construit.

**13.** Système de traitement de données, caractérisé en ce qu'il comporte des moyens pour la mise en oeuvre de chaque étape du procédé selon l'une des revendications 1 à 12.

**Claims**

**1.** Method for automatically generating, with the aid of data-processing apparatus, in a memory zone of this apparatus, an implicit representation (PRIME(f)) of the prime implicants of a Boolean function initially represented, in another memory zone of this apparatus, in the form of a binary decision diagram (f) for this function, consisting in preparing the implicit representation on the basis of the information constituting the decision diagram, by performing recursive traverses across this diagram in order to determine intermediate elements, which are then combined with each other after each recursion, each intermediate element using occurrence variables ($O_1$, ..., $O_n$) and sign variables ($S_1$, ..., $S_n$), corresponding respectively to each of the propositional variables ($x_1$, .., $x_n$) of the decision diagram, characterised in that it consists in constructing in the memory, for each node that does not already exist in the memory and the root of which is the occurrence variable $O_k$ associated with the root variable $x_k$ of the corresponding binary decision diagram, an intermediate element standardised at the time of its preparation according to the relative values of the low branch of said root, consisting of an implicit representation P constructed at the time of a previous recursion, and of the high branch of said root, consisting of another implicit representation P' constructed with the aid of elements obtained at the time of a previous recursion.

**2.** Method according to Claim 1, characterised in that the binary decision diagram of the Boolean function constituting, in a known manner, a node $Nd(x_k,L,H)$, in which $x_k$ is a label or a root variable, L is the low branch associated with that label, H is the high branch associated with that label, it consists, in order to obtain the implicit representation of the prime implicants of the function, in:

- breaking the node down into its low branch L and its high branch H,

- obtaining a standard implicit representation of the prime implicants of each of these branches;
- determining the binary decision diagram (L∧H) associated with the logical intersection of the two branches;
- obtaining a standard implicit representation of the prime implicants of this intersection;
- combining together, according to a predetermined rule, the standard implicit representations in order to obtain a result;
- standardising this result at the time of its preparation.

3. Method according to Claim 2, characterised in that since each branch (L, H) of a node and their intersection (L∧H) can be constituted by a node association, with labels ($x_i$) arriving finally at terminal sheets of a logic value 0 or 1, it consists, in order to obtain implicit representations of the prime implicants of these branches or their intersections, in effecting recursive traverses across each of the nodes thus associated.

4. Method according to one of Claims 2 or 3, characterised in that the implicit representation (PRIME(f)) of the prime implicants of a first node (f), the root of which is $x_k$, the low branch L, the high branch H, is constructed in accordance with:

$$PRIME(f) = STANDARD[O_k, P, Nd(S_k, MINUS\{PRIME(L), P\} \ MINUS\{PRIME(H), P\})],$$

which obeys the following rules: PRIME(0)=0; PRIME(1)=1,
and in which P=PRIME(L∧H) is a second node constituting the implicit representation of the prime implicants of the logical intersection of the low L and high H branches of the node in question;
in which Nd("variable",A,B) prepares a node for which the label is the "variable" element, the low branch the element A and the high branch the element B;
in which STANDARD is a function making it possible to obtain a standard form of a node;
and in which MINUS is a function that, applied to two standard forms, makes it possible to complete the implicit representation.

5. Method according to Claim 4, characterised in that the function STANDARD(x,P,P'), in which x is a variable, and P and P' are two implicit representations, uses tests to compare these two implicit representations and to determine their value, then gives one or other of the following standard results, according to the result of the tests:

$$If \ P=P' \ or \ P'=0, \ then \ STANDARD(x, P, P')=P;$$

$$If \ P=0, \ then \ STANDARD(x, P, P')=P';$$

Otherwise STANDARD(x,P,P')=Nd(x,P,P').

6. Method according to Claim 4, characterised in that the function STANDARD(x,P,P'), in which x is a variable, and P and P' are two implicit representations, uses a first test to compare these two implicit representations and to determine their value, then gives one or other of the following standard results, according to the result of the test:

$$If \ P=P', \ then \ STANDARD(x, P, P')=P;$$

Otherwise STANDARD(x,P,P')=Nd(x,P,P').

7. Method according to Claim 4, characterised in that the function STANDARD(x,P,P'), in which x is a variable, and P and P' are two implicit representations, uses a first test to compare these two implicit representations and to determine their value, then gives one or other of the following standard results, according to the result of the test:

$$If \ P=0, \ then \ STANDARD(x, P, P')=P';$$

Otherwise STANDARD(x,P,P')=Nd(x,P,P).

8. Method according to Claim 4, characterised in that the function MINUS(P,P'), in which P and P' are implicit representations, and which gives an implicit representation, uses a second test to compare these two implicit representations and to determine their value, then gives one or other of the following results, according to the result of the test:

If P=P' or (P=0), then MINUS(P, P')=0;

If P=1 or P'=0 or P'=1, MINUS(P, P')=P.

9. Method according to Claim 8, characterised in that when the result of the second test highlights the fact that P is different from P' and that simultaneously P and P' do not constitute terminal branches, i.e. constitute two distinct nodes, the MINUS function consists in:

- breaking down the node P into its root (v), its low branch L and its high branch H;
- breaking down the node P' into its root (v'), its low branch L' and its high branch H';
- testing whether the roots (v, v') are occurrence or sign variables;
- testing their rank;
- then, depending on the results of the last two tests, giving the following results:

   A) If $v=O_k$ and $v'=O_k'$

      1. If k < k', then:

$$MINUS(P, P')=STANDARD(O_k, MINUS(L,P'),H);$$

      2. If k=k'

$$MINUS(P, P')=STANDARD(O_k, MINUS(L,L'), MINUS2(H,H'));$$

      3. Otherwise:

$$MINUS(P, P')=MINUS(P, L').$$

   B) If $v=O_k$ and $v'=S_k'$

      1. If k < k', then:

$$MINUS(P, P')=STANDARD(O_k, MINUS(L,P'),H);$$

      2. If k=k', then

$$MINUS(P, P')=STANDARD(O_k,L, MINUS2(H, P'));$$

      3. Otherwise: MINUS(P, P')=P

   C) If $v=S_k$ and $v'=O_{k'}$

      1. If k < k', then:

$$(MINUS(P, P')=P;$$

      2. If k=k', then:

$$MINUS(P, P')=MINUS2(P, H');$$

      3. Otherwise:

$$MINUS(P, P')=MINUS(P, L').$$

   D) If $v=S_k$ and $v'=S_k'$

      1. If k=k', then:

$$\text{MINUS}(P, P')=\text{Nd}[S_k, \text{MINUS}(L,L'), \text{MINUS}(H,H')];$$

2. Otherwise:

$$\text{MINUS}(P, P')=P.$$

10. Method according to Claim 8, characterised in that when the result of the second test highlights the fact that P is different from P' and that simultaneously P and P' do not constitute terminal branches, i.e. constitute two distinct nodes, the MINUS function consists in:

- breaking down the node P into its root (v), its low branch L and its high branch H;
- breaking down the node P' into its root (v'), its low branch L' and its high branch H';
- testing whether the roots (v, v') are occurrence or sign variables;
- testing their rank;
- then, depending on the results of the last two tests, giving the following results:

A) If $k < k'$

i) If $v=O_k$ (v is an occurrence variable)

$$\text{MINUS}(P, P')=\text{STANDARD}[O_k, \text{MINUS}(L,P'), H];$$

ii) Otherwise: $\text{MINUS}(P, P')=P$

B) If $k > k'$

i) If $v'=O_k'$ (v' is an occurrence variable),

$$\text{MINUS}(P, P')=\text{MINUS}(P, L')$$

ii) Otherwise: $\text{MINUS}(P, P')=P$

C) If $v=O_k$ (v is an occurrence variable)

i) If $v'=O_k'$ (v' is an occurrence variable), then

$$\text{MINUS}(P, P')=\text{STANDARD}[O_k, \text{MINUS}(L,L'), \text{MINUS2}(H,H')];$$

ii) Otherwise $\text{MINUS}(P, P')=\text{STANDARD}[O_k, L, \text{MINUS2}(H,P')]$ ;

D) Otherwise

i) If $v'=O_k'$

$$\text{MINUS}(P, P')=\text{MINUS2}(P, H');$$

ii) Otherwise:

$$\text{MINUS}(P, P')=\text{Nd}[S_k,\text{MINUS}(L,L'),\text{MINUS}(H,H')].$$

11. Method according to one of Claims 9 or 10, characterised in that the function MINUS2(P,P'), in which P and P' are implicit representations, and which gives an implicit representation, uses a last test to compare these two implicit representations then, depending on the result of the test:

- if $P=P'$ , then MINUS2(P,P')=0
- otherwise the node P is broken down into its root ($S_k$), its low branch L and its high branch H; the node P' is broken down into its root ($S_{k'}$), its low branch L' and its high branch H'; $\text{Nd}(S_k,L,H)=P$ and $\text{Nd}(S_{k'},L',H')=P'$ , then: $\text{MINUS2}(P,P')=\text{Nd}[S_k, \text{MINUS}(L,L'), \text{MINUS}(H,H')]$.

**12.** Method according to one of the preceding claims, characterised in that the processing system is arranged so as to test, following the determination of the parameters of a new node, whether this node already exists in memory and, if so, enter in the data memory allowing this node, already constructed, to be reused.

**13.** Data-processing system, characterised in that it comprises means for implementing each step of the method according to one of Claims 1 to 12.

**Patentansprüche**

**1.** Verfahren, bei dem mit Hilfe einer Datenverarbeitungsvorrichtung in einer Speicherzone dieser Vorrichtung eine implizite Darstellung (PRIME(f)) von Primimplikanten einer Booleschen Funktion, die anfangs in einer anderen Speicherzone dieser Vorrichtung in Form eines binären Entscheidungsdiagramms (f) dieser Funktion dargestellt ist, automatisch erstellt wird, wobei das Verfahren darin besteht, die implizite Darstellung anhand von Informationen zu erstellen, die das Entscheidungsdiagramm bilden, indem rekursive Durchläufe durch dieses Diagramm ausgeführt werden, um die Zwischenelemente zu bestimmen, die anschließend nach jedem Durchlauf miteinander kombiniert werden, wobei jedes Zwischenelement Auftrittsvariable ($O_1$, ..., $O_n$) und Vorzeichenvariable ($S_1$, ..., $S_n$), die entsprechenden propositionalen Variablen ($x_1$, ..., $x_n$) des Entscheidungsdiagramms entsprechen, verwendet, dadurch gekennzeichnet, daß es darin besteht, im Speicher für jeden Knoten, der nicht bereits im Speicher vorhanden ist und dessen Wurzel die Auftrittsvariable ($O_k$) ist, die der Wurzelvariable $x_k$ des entsprechenden binären Entscheidungsdiagramms zugeordnet ist, ein Zwischenelement zu konstruieren, das bei seiner Erstellung mit Werten normiert wird, die auf den unteren Zweig der Wurzel, der aus einer bei einer vorhergehenden Rekursion konstruierten impliziten Darstellung P besteht, und auf den oberen Zweig der Wurzel, der aus einer mit Hilfe von bei einer vorhergehenden Rekursion erhaltenen Elementen konstruierten impliziten Darstellung P' besteht, bezogen sind.

**2.** Verfahren nach Anspruch 1, dadurch gekennzeichnet, daß es dann, wenn das binäre Entscheidungsdiagramm der Booleschen Funktion in bekannter Weise einen Knoten Nd($x_k$, L, H) bildet, worin $x_k$ ein Etikett oder eine Wurzelvariable ist, L der diesem Etikett zugeordnete untere Zweig ist und H der diesem Etikett zugeordnete obere Zweig ist, für die Gewinnung der impliziten Darstellung von Primimplikanten der Funktion darin besteht:

- den Knoten in seinen unteren Zweig L und in seinen oberen Zweig H zu zerlegen,
- eine normierte implizite Darstellung der Primimplikanten jedes dieser Zweige zu gewinnen;
- das binäre Entscheidungsdiagramm (L∧H), das dem logischen Durchschnitt der beiden Zweige zugeordnet ist, zu bestimmen;
- eine normierte implizite Darstellung der Primimplikanten dieses Durchschnitts zu gewinnen,
- die normierten impliziten Darstellungen gemäß einer bestimmten Regel miteinander zu kombinieren, um ein Ergebnis zu gewinnen;
- dieses Ergebnis bei seiner Erstellung zu normieren.

**3.** Verfahren nach Anspruch 2, dadurch gekennzeichnet, daß es dann, wenn jeder Zweig (L, H) eines Knotens und ihr Durchschnitt (L∧H) durch eine Zuordnung des Knotens an Etiketten ($x_i$), die schließlich in abschließenden Blättern mit logischem Wert 0 oder 1 enden, gebildet werden können, für die Gewinnung der impliziten Darstellungen der Primimplikanten dieser Zweige und ihrer Durchschnitte darin besteht, rekursive Durchläufe durch jeden der so zugeordneten Knoten auszuführen.

**4.** Verfahren nach einem der Ansprüche 2 oder 3, dadurch gekennzeichnet, daß die implizite Darstellung (PRIME(f)) der Primimplikanten eines ersten Knotens (f) mit Wurzel ($x_k$), unterem Zweig L und oberem Zweig H folgendermaßen konstruiert wird:

$$PRIME(f) = NORME[O_k, P, Nd(S_k MINUS\{PRIME(L), P\}, MINUS\{PRIME(H), P\})]$$

die die folgenden Regeln befolgt: PRIME(0) = 0; PRIME(1) = 1, und in der P = PRIME(L∧H) ein zweiter Knoten ist, der die implizite Darstellung der Primimplikanten des logischen Durchschnitts des unteren Zweigs L und des oberen Zweigs H des betrachteten Knotens bildet;
in der Nd("Variable", A, B) einen Knoten erstellt, dessen Etikett das Element "Variable" ist, dessen unterer Zweig das Element A ist und dessen oberer Zweig das Element B ist;
in der NORME eine Funktion ist, die ermöglicht, eine normierte Form eines Knotens zu gewinnen;
und in der MINUS eine Funktion ist, die, wenn sie auf zwei normierte Formen angewendet wird, ermöglicht, die implizite Darstellung fertigzustellen.

5.  Verfahren nach Anspruch 4, dadurch gekennzeichnet, daß die Funktion NORME(x, P, P'), worin x eine Variable ist und P und P' zwei implizite Darstellungen sind, Tests ausführt, um diese zwei impliziten Darstellungen zu vergleichen und um ihren Wert zu bestimmen, und dann je nach Ergebnis der Tests das eine oder das andere der folgenden normierten Ergebnisse zu liefern:

wenn P = P' oder P' = 0, dann NORME(x, P, P') = P;

wenn P = 0, dann NORME(x, P, P') = P';

sonst NORME(x, P, P') = Nd(x, P, P').

6.  Verfahren nach Anspruch 4, dadurch gekennzeichnet, daß die Funktion NORME(x, P, P'), worin x eine Variable ist und P und P' zwei implizite Darstellungen sind, einen ersten Test ausführt, um diese zwei impliziten Darstellungen zu vergleichen und um ihren Wert zu bestimmen, und dann je nach Ergebnis des Tests das eine oder das andere der folgenden normierten Ergebnisse liefert:

wenn P = P', dann NORME(x, P, P') = P;

sonst NORME(x, P, P') = Nd(x, P, P').

7.  Verfahren nach Anspruch 4, dadurch gekennzeichnet, daß die Funktion NORME(x, P, P'), worin x eine Variable ist und P und P' zwei implizite Darstellungen sind, einen ersten Test ausführt, um diese zwei impliziten Darstellungen zu vergleichen und um ihren Wert zu bestimmen, und dann je nach Ergebnis des Tests das eine oder das andere der folgenden normierten Ergebnisse liefert:

wenn P = 0, dann NORME(x, P, P') = P';

sonst NORME(x, P, P') = Nd(x, P, P').

8.  Verfahren nach Anspruch 4, dadurch gekennzeichnet, daß die Funktion MINUS(P, P'), worin P und P' implizite Darstellungen sind und die eine implizite Darstellung liefert, einen zweiten Test ausführt, um diese zwei impliziten Darstellungen zu vergleichen und um ihren Wert zu bestimmen, und dann je nach Ergebnis des Tests das eine oder das andere der folgenden Ergebnisse liefert:

wenn P = P' oder (P = 0), dann MINUS(P, P') = 0;

wenn P = 1 oder P' = 0 oder P' = 1, dann MINUS(P, P') = P.

9.  Verfahren nach Anspruch 8, dadurch gekennzeichnet, daß die Funktion MINUS dann, wenn das Ergebnis des zweiten Tests ergibt, daß P von P' verschieden ist und gleichzeitig P und P' keine abschließenden Zweige bilden, d. h. zwei verschiedene Knoten bilden, darin besteht:

-   den Knoten P in seine Wurzel (v), seinen unteren Zweig (L) und seinen oberen Zweig (H) zu zerlegen;
-   den Knoten P' in seine Wurzel (v'), seinen unteren Zweig (L') und seinen oberen Zweig (H') zu zerlegen;
-   zu testen, ob die Wurzeln (v, v') Auftritts- oder Vorzeichenvariablen sind;
-   ihren Rang zu testen;
-   dann in Abhängigkeit von den Ergebnissen dieser beiden letzteren Tests die folgenden Ergebnisse zu liefern:

A) wenn $v = O_k$ und $v' = O_k'$

1.  wenn k < k', dann:

$$MINUS(P, P') = NORME(O_k, MINUS(L, P'), H);$$

2.  wenn k = k' :

$$MINUS(P, P') = NORME(O_k, MINUS(L, L'), MINUS2(H, H'));$$

        3. sonst:

$$MINUS(P, P') = MINUS(P, L').$$

    B) wenn $v = O_k$ und $v' = S_k'$

        1. wenn k < k', dann:

$$MINUS(P, P') = NORME(O_k, MINUS(L, P'), H);$$

        2. wenn k = k', dann:

$$MINUS(P, P') = NORME(O_k, L, MINUS2(H, P'));$$

        3. sonst: $MINUS(P, P') = P$

    C) wenn $v = S_k$ und $v' = O_k'$

        1. wenn k < k', dann:

$$MINUS(P, P') = P;$$

        2. wenn k = k', dann:

$$MINUS(P, P') = MINUS2(P, H');$$

        3. sonst:

$$MINUS(P, P') = MINUS(P, L').$$

    D) wenn $v = S_k$ und $v' = S_k'$

        1. wenn k = k', dann:

$$MINUS(P, P') = Nd[S_k, MINUS(L, L'), MINUS(H, H')];$$

        2. sonst:

$$MINUS(P, P') = P.$$

**10.** Verfahren nach Anspruch 8, dadurch gekennzeichnet, daß die Funktion MINUS dann, wenn das Ergebnis des zweiten Tests ergibt, daß P von P' verschieden ist und gleichzeitig P und P' keine abschließenden Zweige bilden, d. h. zwei verschiedene Knoten bilden, darin besteht:

-     den Knoten P in seine Wurzel v, seinen unteren Zweig L und seinen oberen Zweig H zu zerlegen;
-     den Knoten P' in seine Wurzel v', seinen unteren Zweig L' und seinen oberen Zweig H' zu zerlegen;
-     zu testen, ob die Wurzeln (v, v') Auftritts- oder Vorzeichenvariablen sind;
-     ihren Rang zu testen;
-     dann in Abhängigkeit von den Ergebnissen dieser zwei letzteren Tests die folgenden Ergebnisse zu liefern:

    A) wenn k < k'

        i) wenn $v = O_k$ (v ist eine Auftrittsvariable)

$$MINUS(P, P') = NORME[O_k, MINUS(L, P'), H];$$

ii) sonst: MINUS(P, P') = P

B) wenn k > k'

i) wenn v' = $O_k$' (v' ist eine Auftrittsvariable)

$$MINUS(P, P') = MINUS(P, L')$$

ii) sonst MINUS(P, P') = P

C) wenn v = $O_k$ (v ist eine Auftrittsvariable)

i) wenn v' = $O_k$' (v' ist eine Auftrittsvariable), dann:

$$MINUS(P, P') = NORME[O_k, MINUS(L, L'), MINUS2(H, H')];$$

ii) sonst MINUS(P, P') = NORME[$O_k$, L, MINUS2(H, P')];

D) sonst

i) wenn v' = $O_k$'

$$MINUS(P, P') = MINUS2(P, H');$$

ii) andernfalls:

$$MINUS(P, P') = Nd[S_k, MINUS(L, L'), MINUS(H, H')]$$

**11.** Verfahren nach einem der Ansprüche 9 oder 10, dadurch gekennzeichnet, daß die Funktion MINUS2(P, P'), worin P und P' implizite Darstellungen sind und die eine implizite Darstellung liefert, einen letzten Test ausführt, um diese zwei impliziten Darstellungen zu vergleichen und je nach Ergebnis des Tests:

- wenn P = P', dann MINUS2(P, P') = 0
- sonst wird der Knoten P in seine Wurzel ($S_k$), seinen unteren Zweig L und seinen oberen Zweig H zerlegt; und wird der Knoten P' in seine Wurzel ($S_k$'), seinen unteren Zweig L' und seinen oberen Zweig H' zerlegt; Nd($S_k$, L, H) = P und Nd($S_k$', L', H') = P', dann

$$MINUS2(P, P') = Nd[S_k, MINUS(L, L'), MINUS(H, H')].$$

**12.** Verfahren nach einem der vorhergehenden Ansprüche, dadurch gekennzeichnet, daß das Verarbeitungssystem so beschaffen ist, daß es nach der Bestimmung der Parameter eines neuen Knotens testet, ob dieser Knoten bereits im Speicher vorhanden ist, und im positiven Fall in den Speicher Daten schreibt, die die erneute Verwendung dieses bereits konstruierten Knotens ermöglichen.

**13.** Datenverarbeitungssystem, dadurch gekennzeichnet, daß es Mittel enthält, um jeden Schritt des Verfahrens nach einem der Ansprüche 1 bis 12 auszuführen.

$x_1$

$f$

$L$

$x_2$

$1$

$x_3$

$\emptyset$

$1$

$H$

$x_2$

$\emptyset$

$1$

# Fig.1

| $Ad_n$ | VAR | $IND_L$ | $IND_H$ | GEST |
|--------|-----|---------|---------|------|
| $Ad_1$ | $x_1$ | "$Ad_2$" | "$Ad_3$" | |
| $Ad_2$ | $x_2$ | "Val 1" | "$Ad_4$" | |
| $Ad_3$ | $x_2$ | "Val $\emptyset$" | "Val 1" | |
| $Ad_4$ | $x_3$ | "Val $\emptyset$" | "Val 1" | |

# Fig.2

O$_k$

Ø

S$_k$

L         H

I

S$_k$

L         H

Norme_I

# Fig.3

X$_2$

Ø         1

H(fig 1)

$\longrightarrow$ L$\frown$H=Ø $\longrightarrow$

S2

Ø         1

Prime (H(fig 1))

# Fig.4

FIG.5

L ⌒ ⌒ x₂

L⌒H= ∅

x₃

0          1

(L⌒H) (fig1)

# FIG.6

O₂

∅

S₂

∅

S₃

∅          1

S₂

∅

S₃

∅          1

Prime((L⌒H)(fig1))

# FIG.7

FIG.8

FIG.9

|  | VAR | IND$_L$ | IND$_H$ | GEST |
|---|---|---|---|---|
| Ad$_1$ | S$_2$ | $\emptyset$ | 1 | Prime H |
| Ad$_2$ | S$_3$ | $\emptyset$ | 1 | Element Prime(L) |
| Ad$_3$ | O$_2$ | Ad$_2$ | Ad$_4$ | Element Prime(L) |
| Ad$_4$ | S$_2$ | 1 | $\emptyset$ | Element Prime(L) |
| Ad$_5$ | S$_2$ | $\emptyset$ | Ad$_2$ | Prime L⌒H |
| Ad$_6$ | O$_1$ | Ad$_5$ | Ad$_7$ | Prime(f).début |
| Ad$_7$ | S$_1$ | Ad$_3$ | Ad$_1$ |  |
| Ad$_8$ |  |  |  |  |

# FIG.10